# FASCICULE DE BREVET EUROPEEN

(11) **EP 1 544 178 B1**
(45) Date de publication et mention de la délivrance du brevet: **12.08.2009**
(21) Numéro de dépôt: 03028874.0
(22) Date de dépôt: 16.12.2003
(51) Int. Cl.: C03C 17/34, G04B 39/00, H03K 17/94, G06F 3/033

(54) **Procédé de fabrication d'un élément transparent à électrodes invisibles**
Verfahren zur Herstellung eines transparenten Elements mit unsichtbaren Elektroden
Method for making a transparent element comprising invisible electrodes

(43) Date de publication de la demande: 22.06.2005
(73) Titulaire: ASULAB S.A., 2074 Marin (CH)
(72) Inventeur: Grupp, Joachim, 2073 Enges (CH); Poli, Gian-Carlo, 2206 Les Geneveys-sur-Coffrane (CH)
(74) Mandataire: Rossand, Isabelle

(56) Documents cités:
- DE-A- 19 636 970
- US-A- 5 556 694
- PATENT ABSTRACTS OF JAPAN vol. 0102, no. 12 (P-480), 24 juillet 1986 (1986-07-24) & JP 61 051101 A (TORAY IND INC), 13 mars 1986 (1986-03-13)

## Description

### DOMAINE TECHNIQUE

La présente invention concerne un procédé de fabrication d'un élément transparent comportant des électrodes dont les contours ne peuvent pas être discernés dans le domaine de longueurs d'onde de la lumière visible grâce à un agencement particulier des matériaux diélectriques transparents permettant d'avoir aussi un effet anti-reflets.

### ARRIERE PLAN TECHNOLOGIQUE

Par "élément transparent", on entend de façon non limitative des verres de lunette, des glaces de montres, des écrans tactiles à électrodes transparentes, par exemple structurées sur des glaces de montre, voire les plaquettes transparentes d'une cellule d'affichage à cristaux liquides ou d'une cellule photovoltaïque.

De façon connue on obtient un effet anti-reflets en effectuant sur un substrat transparent (S) un empilement comprenant au moins une couche d'un matériau diélectrique transparent d'indice de réfraction élevé (H) et une couche d'un deuxième matériau diélectrique transparent d'indice de réfraction faible (L).

Un procédé du type précédent est par exemple décrit dans le brevet français FR 2 751 638. Un substrat en verre est revêtu, par LPCVD à partir de précurseurs gazeux d'une mince couche de TiO₂ (n = 2,35), puis d'une couche plus épaisse de SiO₂ (n = 1,46), l'opération pouvant être renouvelée une deuxième fois, ce qui conduit à une séquence pouvant être résumée par "SHLHL".

On trouve également une séquence du même type dans le brevet américain US 5,170,291, mais employant des diélectriques différents, un des exemples donnés comprenant successivement TiO₂ (n = 2,4)/Al₂O₃ (n = 1,6) / TiO2 (n = 2,4) / SiO₂ (n = 1,48), ce qui correspond à la séquence "SHL₁HL₂".

Lorsque le substrat transparent doit comporter des électrodes, par exemple pour constituer un écran de commande tactile capacitif dans la glace d'une montre-bracelet, une couche d'ITO, ou d'un autre oxyde conducteur transparent (TCO) est déposée sur la dernière couche de diélectrique, structurée avec un revêtement final en un matériau diélectrique à faible indice de réfraction. Ce procédé peut donc être représenté par la séquence "SHL₁ (TCO) L₂". Il donne de très bons résultats, c'est à dire qu'il permet de rendre les électrodes pratiquement invisibles, mais il présente plusieurs inconvénients. Il est d'abord coûteux en raison du nombre de couches différentes devant être déposées par CVD ou procédés équivalents. Il est également délicat à mettre en oeuvre, en particulier dans l'étape de structuration des électrodes où le risque est grand d'endommager la dernière couche de diélectrique et donc de créer de nouveaux problèmes d'interférences rendant encore certains contours d'électrodes visibles. On observera enfin que la dernière couche de diélectrique de faible indice de réfraction, généralement MgF₂ (n = 1,37), présente une faible résistance à l'abrasion de sorte qu'il existe également un risque d'endommager ladite couche lors des manipulations pour le montage de l'écran tactile dans le boîtier d'une montre-bracelet.

Le document de brevet JP 61 051101 enseigne que l'on peut revêtir des électrodes conductrices transparentes par exemple en oxyde d'étain-antimoine ou ITO d'un film diélectrique dur présentant en outre des propriétés antireflets. Cela correspond à un empilement comprenant au moins une couche d'un matériau diélectrique transparent d'indice de réfraction élevé (H) et une couche d'un deuxième matériau diélectrique transparent d'indice de réfraction faible (L) sur un substrat (S).

Dans le document de brevet US-A-5,556,694, on a un empilement de plusieurs couches de type SLHL.

### RESUME DE L'INVENTION

La présente invention a donc pour objet de pallier les inconvénients de l'art antérieur précité en procurant un procédé plus facile et plus économique à mettre en oeuvre pour obtenir un produit final moins délicat à manipuler. L'invention concerne plus particulièrement le cas où l'élément transparent est formé par un substrat transparent en saphir ou en verre trempé et comporte sur une de ses faces une structuration d'électrodes destinée à former des capteurs capacitifs.

A cet effet l'invention a pour objet un procédé consistant à former sur un substrat transparent un réseau conducteur en un oxyde transparent conducteur (TCO) comportant des électrodes, des pistes conductrices et des zones de contact, puis à déposer une première couche d'un diélectrique transparent d'indice de réfraction faible (L) et ensuite une deuxième couche d'un autre diélectrique transparent d'indice de réfraction plus élevé que le premier.

Par rapport à l'art antérieur cité au début, le procédé selon l'invention peut se résumer par l'obtention d'un élément transparent à électrodes invisibles correspondant à la séquence "S (TCO) LH".

Le procédé permet d'avoir de très bonnes propriétés anti-reflets, mais aussi une excellente compensation optique et une bien meilleure résistance à l'abrasion, compte tenu des choix possibles pour le matériau diélectrique formant la couche la plus externe.

Dans un mode d'application préféré, le substrat est en saphir ou en verre trempé et le procédé permet d'obtenir des écrans tactiles capacitifs, notamment pour constituer des glaces de montre qui doivent être parfaitement transparentes pour avoir une bonne lecture des informations portées par le cadran.

### BREVE DESCRIPTION DES DESSINS

D'autres caractéristiques et avantages de la présente invention apparaîtront dans la description suivante donnée à titre illustratif et non limitatif, en référence aux dessins annexés dans lesquels :
- la figure 1 est une vue de dessous d'une glace de montre comportant des capteurs tactiles capacitifs, et
- la figure 2 est une représentation en coupe selon la ligne II-II de la figure 1 de l'empilement des différentes couches.

### DESCRIPTION DETAILLEE DE L'INVENTION

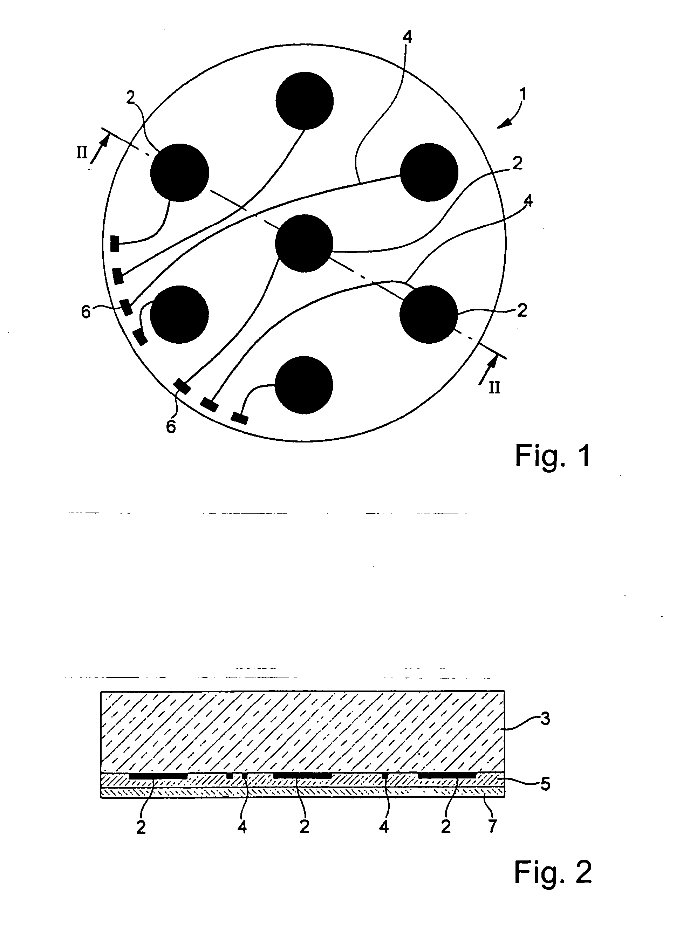

A la figure 1, on a représenté en vue de dessous une glace 1 en saphir ou en verre trempé, destinée à être montée dans une montre-bracelet ladite glace 1 étant formée par un substrat transparent 3 comportant un réseau en oxydes conducteurs transparents (TCO) formant les électrodes de capteurs tactiles capacitifs 2 activables par le contact d'un doigt sur la surface externe de la glace 1, lesdits capteurs 2 étant reliés par des pistes conductrices 4 à des zones de contact périphériques 6, elles-mêmes reliées au mouvement électronique de la montre-bracelet et/ou à des microprocesseurs pour commander des fonctions horaires ou non horaires. Bien que les contrastes aient fortement été exagérés sur la figure 1, tous ces éléments conducteurs 2, 4, 6 seraient visibles à travers la glace 1, en particulier en observation oblique, si aucun traitement n'était effectué.

En se référant maintenant à la figure 2, on décrit ci-après le procédé selon l'invention qui permet de rendre invisibles les capteurs 2, les pistes conductrices 4, et avec une moindre nécessité les zones de contact 6 qui peuvent être masquées par un rehaut ou par la lunette.

Dans une première étape le substrat 3 en saphir ou en verre trempé est revêtu sur toute sa surface d'un film de TCO. On effectue par exemple par évaporation un dépôt d'oxyde d'étain et d'indium (ITO) ayant une épaisseur comprise entre 25 nm et 75 nm de préférence entre 45 nm et 55nm. Le TCO pourrait également être choisi parmi In₂O₃ et SnO₂ dopé à l'antimoine. On effectue ensuite un gravage par attaque chimique pour éliminer le TCO dans toutes les zones ne correspondant pas aux capteurs 2, aux pistes conductrice 4, et aux zones de contact 6. On élimine enfin par "stripping" les parties résiduelles du masque avec un solvant approprié par ultrasons.

Dans une deuxième étape on introduit le substrat dans une enceinte et on effectue, par des techniques connues de dépôts en phase vapeur, de préférence des dépôts physiques en phase vapeur (PVD), ou par des techniques apparentées (PACVD, PECVD, LICVD, etc...) à partir d'une cible, le dépôt d'une première couche 5 d'un diélectrique transparent ayant un indice de réfraction faible (L). De préférence ce dépôt est effectué en ayant préalablement porté le substrat 3 comportant le réseau conducteur 2, 4, 6 à une température d'environ 250°C sous pression partielle d'oxygène lorsque le TCO est de l'ITO.

Dans une troisième étape, on maintient le substrat dans la même enceinte et on effectue selon les mêmes procédés le dépôt d'une deuxième couche 7 d'un autre diélectrique transparent ayant un indice de réfraction (H) plus élevé que celui de la première couche 5.

Les matériaux diélectriques utilisables pour former les première et deuxième couches sont des composés bien connus, pouvant être choisis par exemple parmi les composés suivants, classés par ordre croissant d'indices de réfraction : MgF₂, LiF, SiO₂, SiOₓ, Al₂O₃, Si₃N₄, ZnS, TiO₂, AIN, Ta₂O₅ et DLC (diamond-like carbon).

Il est par exemple possible d'utiliser pour la première couche 5 un fluorure de magnésium ou de lithium, ayant des indices de réfraction faibles (L), à savoir respectivement n = 1,37 pour MgF₂, et n = 1,39 pour LiF, lorsque le dépôt est effectué par PVD. Cette première couche a une épaisseur comprise entre 50 nm et 100 nm, de préférence environ 60 nm.

Pour former la deuxième couche 7, on choisit un matériau diélectrique d'indice de réfraction plus élevé, tel que l'alumine (n = 1,70), le pentoxyde de tantale (n = 2,4) ou le diamond-like carbon. L'épaisseur de la deuxième couche 7 est comprise entre 8 nm et 25 nm, de préférence environ 16 nm. Cette deuxième couche la plus externe présente également l'avantage d'avoir une bonne résistance à l'abrasion.

Ces deux étapes de dépôts de diélectriques, d'abord d'indice de réfraction faible puis d'indice de réfraction plus élevé peuvent être répétées au moins une fois, ce qui correspond à la séquence S (TCO) LHLH.

Il est également possible, dans le cadre de la présente invention d'utiliser d'autres couples de diélectriques UH, y compris dans le cas où on a une séquence S (TCO) LHLH, tels que SiO₂/Si₃N₄ ou Al₂O₃/AlN. Ce dernier exemple montre également qu'un même diélectrique, dans ce cas Al2O3, peut être considéré de type "H" s'il est associé à un deuxième diélectrique d'indice plus faible ou au contraire de type "L" s'il est associé à un deuxième diélectrique d'indice plus élevé ( n = 2,38 pour AIN)

## Revendications

1. Procédé de fabrication d'un élément transparent (1) à électrodes invisibles formé par un substrat (3) transparent dont une face est pourvue d'un réseau conducteur constitué par des électrodes (2), des pistes conductrices (4) et des zones de contact (6), **caractérisé en ce qu'**il comporte les étapes suivantes :
- déposer sur toute la surface du substrat (3) un film d'oxyde transparent conducteur (TCO), éliminer par attaque chimique à travers un masque les zones de TCO ne constituant pas le réseau conducteur (2, 4, 6), puis les parties résiduelles du masque
- déposer une première couche (5) d'un diélectrique transparent ayant un indice de réfraction faible (L)
- déposer une deuxième couche d'un autre diélectrique transparent ayant un indice de réfraction élevé (H) par rapport à celui de la première couche, cette deuxième couche de matériau diélectrique formant la couche la plus externe.

2. Procédé selon la revendication 1, **caractérisé en ce que** l'oxyde transparent conducteur est un oxyde d'étain et d'indium (ITO)

3. Procédé selon la revendication 2, **caractérisé en ce que** le substrat (3) est préalablement porté à une température d'environ 250°C sous pression partielle d'oxygène avant d'effectuer le dépôt de la première couche (5) de diélectrique.

4. Procédé selon la revendication 1, **caractérisé en ce que** les dépôts de diélectriques (L, H) sont effectués dans la même enceinte.

5. Procédé selon la revendication 1, **caractérisé en ce que** les diélectriques des première (5) et deuxième (7) couches sont choisis parmi les composés suivants classés par ordre croissant d'indices de réfraction : MgF₂, LiF, SiO₂, SiOₓ, Al₂O3, Si₃N₄, ZnS, TiO₂, AIN, Ta₂O5 et DLC.

6. Procédé selon les revendications 3 et 5, **caractérisé en ce que** le diélectrique de la première couche (5) est un fluorure de magnésium ou de lithium et celui de la deuxième couche (7), de l'alumine, du pentoxyde de tantale ou du diamond-like carbone.

7. Procédé selon la revendication 1, **caractérisé en ce que** la première couche (5) a une épaisseur comprise entre 50 nm et 100 nm, de préférence environ 60 nm et **en ce que** la deuxième couche a une épaisseur comprise entre 8 nm et 25 nm, de préférence environ 16 nm.

8. Procédé selon la revendication 1, **caractérisé en ce que** le substrat transparent (3) est en saphir ou en verre trempé.

9. Procédé selon l'une quelconque des revendications précédentes, **caractérisé en ce que** les dépôts des couches diélectriques (5, 7) sont renouvelés au moins une fois en conservant l'ordre L, H.

10. Procédé selon la revendication 1, **caractérisé en ce que** les électrodes (2) constituent les capteurs d'un écran tactile capacitif.

11. Procédé selon la revendication 1, **caractérisé en ce que** l'élément transparent est une glace de montre-bracelet.

## Claims

1. Method of manufacturing a transparent element (1) with invisible electrodes formed by a transparent substrate (3) one face of which is provided with a conductive pattern formed by electrodes (2), conductive paths (4) and contact zones (6), **characterised in that** it includes the steps of:
- depositing over the entire surface of the substrate (3) a transparent conductive oxide film (TCO), removing via chemical etching through a mask the zones of TCO that do not form the conductive pattern (2, 4, 6), then the residual parts of the mask,
- depositing a first layer (5) of a transparent dielectric material having a low refractive index (L),
- depositing a second layer of another transparent dielectric material having a high refractive index (H) relative to that of the first layer, this second layer of dielectric material forming the outermost layer.

2. Method according to claim 1, **characterised in that** the transparent conductive oxide is a tin and indium oxide (ITO).

3. Method according to claim 2, **characterised in that** the substrate (3) is previously brought to a temperature of around 250°C under oxygen partial pressure before deposition of the first dielectric layer (5) is carried out.

4. Method according to claim 1, **characterised in that** the dielectric depositions (L, H) are carried out in the same closed chamber.

5. Method according to claim 1, **characterised in that** the dielectrics of the first (5) and second (7) layers are chosen from among the following compounds classed by order of increasing refractive index; MgF₂, LiF, SiO₂, SiOₓ, AlO₃, Si₃N₄, ZnS, TiO₂, AIN, Ta₂O₅ and DLC (diamond-like carbon).

6. Method according to claim 3 and 5, **characterised in that** the dielectric of the first layer (5) is a magnesium or lithium fluoride and that of the second layer (7), is alumina, tantalum pentoxide or diamond-like carbon.

7. Method according to claim 1, **characterised in that** the first layer (5) has a thickness comprised between 50 nm and 100 nm, preferably around 60 nm and **in that** the second layer has a thickness comprised between 8 nm and 25 nm, preferably around 16 nm.

8. Method according to claim 1, **characterised in that** the transparent substrate (3) is made of sapphire or toughened glass.

9. Method according to any of the preceding claims, **characterised in that** the depositions of the dielectric layers (5, 7) are renewed at least once keeping the order L, H.

10. Method according to claim 1, **characterised in that** the electrodes (2) form the sensors of a capacitive touch screen.

11. Method according to claim 1, **characterised in that** the transparent element is a wristwatch glass.

## Patentansprüche

1. Verfahren zum Herstellen eines lichtdurchlässigen Elements (1) mit unsichtbaren Elektroden, das durch ein lichtdurchlässiges Substrat (3) gebildet ist, wovon eine Fläche mit einem Leiternetz versehen ist, das durch die Elektroden (2), durch Leiterbahnen (4) und durch Kontaktzonen (6) gebildet ist, **dadurch gekennzeichnet, dass** es die folgenden Schritte umfasst:
- Anordnen einer lichtdurchlässigen dünnen Leiteroxidschicht (TCO) auf der gesamten Oberfläche des Substrats (3), Beseitigen durch chemische Ätzung durch eine Maske der TCO-Zonen, die nicht das Leiternetz (2, 4, 6) bilden, und dann der restlichen Teile der Maske,
- Anordnen einer ersten Schicht (5) aus einem lichtdurchlässigen Dielektrikum, das einen geringen Brechungsindex (L) besitzt,
- Anordnen einer zweiten Schicht aus einem anderen lichtdurchlässigen Dielektrikum, das einen in Bezug auf jenen der ersten Schicht hohen Brechungsindex (H) besitzt, wobei diese zweite Schicht aus dielektrischem Material die äußerste Schicht bildet.

2. Verfahren nach Anspruch 1, **dadurch gekennzeichnet, dass** das lichtdurchlässige Leiteroxid ein Oxid aus Zinn und Indium (ITO) ist.

3. Verfahren nach Anspruch 2, **dadurch gekennzeichnet, dass** das Substrat (3) im Voraus auf eine Temperatur von etwa 250 °C unter Sauerstoff partialdruck gebracht wird, bevor die Aufbringung der ersten Dielektrikum-Schicht (5) erfolgt.

4. Verfahren nach Anspruch 1, **dadurch gekennzeichnet, dass** die Aufbringungen der Dielektrika (L, H) im selben Behälter erfolgt.

5. Verfahren nach Anspruch 1, **dadurch gekennzeichnet, dass** die Dielektrika der ersten Schicht (5) und der zweiten Schicht (7) unter den folgenden Verbindungen gewählt sind, die in der Reihenfolge zunehmender Brechungsindizes aufgelistet sind: MgF₂, LiF, SiO₂, SiOₓ, Al₂O₃, Si₃N₄, ZnS, TiO₂, AIN, Ta₂O₅ und DLC.

6. Verfahren nach den Ansprüchen 3 und 5, **dadurch gekennzeichnet, dass** das Dielektrikum der ersten Schicht (5) Magnesium- oder Lithiumfluorid ist, und jenes der zweiten Schicht (7) Aluminiumoxid, Tantalpentoxid oder diamantartiger Kohlenstoff ist.

7. Verfahren nach Anspruch 1, **dadurch gekennzeichnet, dass** die erste Schicht (5) eine Dicke im Bereich von 50 nm bis 100 nm und vorzugsweise von etwa 60 nm hat und dass die zweite Schicht eine Dicke im Bereich von 8 nm bis 25 nm und vorzugsweise von 16 nm hat.

8. Verfahren nach Anspruch 1, **dadurch gekennzeichnet, dass** das lichtdurchlässige Substrat (3) Saphir oder Hartglas ist.

9. Verfahren nach einem der vorhergehenden Ansprüche, **dadurch gekennzeichnet, dass** die Aufbringungen der dielektrischen Schichten (5, 7) unter Beibehaltung der Ordnung L, H wenigstens einmal erneuert werden.

10. Verfahren nach Anspruch 1, **dadurch gekennzeichnet, dass** die Elektroden (2) die Sensoren eines kapazitiven Berührungsschirms bilden.

11. Verfahren nach Anspruch 1, **dadurch gekennzeichnet, dass** das lichtdurchlässige Element ein Glas einer Armbanduhr ist.
